# EUROPEAN PATENT SPECIFICATION

(11) **EP 3 257 698 B1**
(45) Date of publication and mention of the grant of the patent: **09.11.2022**
(21) Application number: 17175060.7
(22) Date of filing: 08.06.2017
(51) Int. Cl.: B60L 3/00, B60K 1/00, B60L 3/04, H05K 7/14, B60L 15/00, B60R 16/04, B60K 1/04, H02M 1/32

(54) **IN-VEHICLE STRUCTURE OF ELECTRIC-POWER CONVERTER**
FAHRZEUGINTERNE STRUKTUR EINES STROMWANDLERS
STRUCTURE EMBARQUÉE DE CONVERTISSEUR D'ÉNERGIE ÉLECTRIQUE

(30) Priority: 13.06.2016 JP 2016117126
(43) Date of publication of application: 20.12.2017
(73) Proprietor: Toyota Jidosha Kabushiki Kaisha, Toyota-shi, Aichi-Ken 471-8571 (JP)
(72) Inventor: BABA, Ryusuke, TOYOTA-SHI, AICHI-KEN, 471-8571 (JP); YAMANAKA, Kenshi, TOYOTA-SHI, AICHI-KEN, 471-8571 (JP)
(74) Representative: Cabinet Beau de Loménie

(56) References cited:
- US-A1- 2006 201 753
- US-A1- 2009 256 420
- US-A1- 2013 241 282
- US-A1- 2013 270 862
- US-A1- 2014 286 060
- US-A1- 2014 339 009

## Description

### BACKGROUND OF THE INVENTION

### 1. Field of the Invention

The present invention relates to an in-vehicle structure of an electric-power converter that converts electric power of an electric power source into driving electric power for a traction motor.

### 2. Description of Related Art

An electric vehicle includes an electric-power converter configured to convert electric power of an electric power source into driving electric power for a traction motor. Note that the "electric vehicle" in the present specification includes not only an automobile provided with only an electric motor as a power source, but also an automobile provided with both a motor and an engine configured to generate a driving force for traveling. Further, the "electric vehicle" described in the present specification also includes a car provided with an electric power source (e.g., a fuel cell) other than a battery.

One type of the electric vehicle includes a traction motor and an electric-power converter provided in a front compartment (a space in front of a cabin). The electric-power converter may be fixed onto a motor housing in which a motor is accommodated (e.g., Japanese Patent Application Publication No. 2012-95482 (JP 2012-95482 A)). In one type of the electric-power converter, a connector for connecting a wiring harness for power supply to an auxiliary battery is provided on a top face of the electric-power converter (e.g., FIG. 1 in Japanese Patent Application Publication No. 2015-133803 (JP 2015-133803 A)). Note that the auxiliary battery is a battery configured to supply electric power to a device (e.g., a control board in the electric-power converter) operating with a voltage lower than a drive voltage for a traction motor. Another example of prior art can be found in US2014/339009.

### SUMMARY OF THE INVENTION

One type of the electric-power converter includes a capacitor configured to restrain a high-frequency fluctuation in a voltage of electric power supplied from an electric power source, and a discharge circuit configured to discharge the capacitor. The electric-power converter discharges the capacitor upon receipt of an instruction signal (a discharge instruction signal) from another device connected to a sensor (a pre-crash safety sensor, an air bag sensor, and the like) that detects a collision. Accordingly, a housing for the electric-power converter is provided with a connector (a signal connector) to which a wiring harness for signal communication to transmit the instruction signal is connected. Conventionally, the signal connector might be also provided on a top face of the electric-power converter similarly to the connector of JP 2015-133803 A.

When the electric-power converter is fixed onto a motor housing, the electric-power converter is placed in front of a cowl top. The cowl top curves like a halfpipe in order to store a wiper pivot therein, and its upper part sticks out toward a vehicle front side when viewed from a vehicle width direction. In a case where the signal connector is provided on the top face of the electric-power converter, when the electric-power converter that has received a collision load moves rearward at the time of a front collision or an oblique collision, the signal connector might make contact with the cowl top provided on a rear side. When the signal connector makes contact with the cowl top, the signal connector is damaged, so that a discharge instruction signal transmitted via the signal connector might not reach a discharge circuit and the discharge circuit might not operate appropriately. The present specification provides a structure in which a signal connector for transmitting a discharge instruction signal can hardly break at the time of a collision.

The present specification discloses an in-vehicle structure of an electric-power converter that converts electric power of an electric power source into driving electric power for a traction motor. In order to prevent contact between a signal connector and a cowl top at the time of a collision, it is conceivable that the signal connector is changed to be placed on a front face of the electric-power converter, on a rear face thereof at a position lower than the cowl top, or on a side face thereof facing in a vehicle width direction. However, the front face easily receives an impact at the time of a front collision, so the front face is not suitable for protection of the signal connector. At the position lower than the cowl top on the rear face, a high-voltage connector to which a power cable through which the electric power of the electric power source is transmitted to the electric-power converter is connected might be provided. Accordingly, in a range, of the rear face, which is lower than the cowl top, it might be difficult to secure a space in which the signal connector is placed. In view of this, in the in-vehicle structure described in the present specification, a signal connector is placed on the side face of the electric-power converter, the side face being facing in the vehicle width direction. With such a configuration, the signal connector can hardly break at the time of a collision in comparison with a case where the signal connector is placed in the other places.

The electric-power converter described in the present specification is fixed onto a motor housing in which a motor is accommodated and is also placed in front of a cowl top. A high-voltage connector to which a power cable through which the electric power of the electric power source is transmitted to the electric-power converter is connected is provided on a surface of the electric-power converter at a position lower than the cowl top, the surface being facing toward a vehicle rear side. The electric-power converter includes a capacitor configured to restrain a high-frequency fluctuation in a voltage of the electric power supplied from the electric power source, and a discharge circuit configured to discharge the capacitor. A signal connector to which a wiring harness for communication of a discharge instruction signal to operate the discharge circuit at a time of a collision is connected is provided on a side face of the electric-power converter, the side face facing in a vehicle width direction. The signal connector is provided on the side face of the electric-power converter and on a vehicle front side relative to a rear end of the electric-power converter, the side face of the electric-power converter being facing in the vehicle width direction. With such a configuration, when the electric-power converter moves backward at the time of a collision, the electric-power converter makes contact with the cowl top earlier than the signal connector so as to push the cowl top rearward. Besides, the signal connector is provided on the side face of the electric-power converter and on the vehicle front side relative to the rear end of the electric-power converter. Accordingly, even if the cowl top deforms and partially enters a lateral side of the electric-power converter, the cowl top thus deforming hardly hits the signal connector. As such, when the signal connector is provided on the side face of the electric-power converter and on the front side relative to the rear end of the electric-power converter, it is possible to avoid such a situation that the signal connector makes contact with the cowl top. With the in-vehicle structure, it is possible to reduce the possibility that the signal connector is damaged, as compared with a case where the signal connector is placed on the front face of the electric-power converter.

The signal connector may be positioned at a height similar to the cowl top, but it is preferable that the signal connector be provided on the electric-power converter at a position lower than the cowl top. In the former case, when the electric-power converter moves backward, the rear end of the electric-power converter makes contact with the cowl top so as to push the cowl top rearward. Accordingly, the signal connector provided on the side face of the electric-power converter which faces in the vehicle width direction is less likely to make contact with the cowl top. In the latter case, it is further possible to reduce the possibility that the signal connector makes contact with the cowl top.

Note that the high-voltage connector to which a power cable for transmission of electric power of the electric power source is connected is connected to the rear face of the electric-power converter at a position lower than the cowl top. With this structure, it is also possible to avoid such a situation that the high-voltage connector makes contact with the cowl top at the time of a collision. Technical details described in the present specification and further improvements thereof are described in "DETAILED DESCRIPTION OF EMBODIMENTS."

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a block diagram of a driving system of a hybrid vehicle that employs an electric-power converter targeted for an in-vehicle structure of an embodiment;
FIG. 2 is a perspective view illustrating a device layout in a front compartment of the hybrid vehicle;
FIG. 3 is a view of the electric-power converter provided in the vehicle when viewed from a vehicle front side;
FIG. 4 is a sectional view taken along a line IV-IV in FIG. 3;
FIG. 5 is a view of an electric-power converter in a conventional in-vehicle structure when viewed from a vehicle width direction;
FIG. 6 is a view illustrating an in-vehicle structure of a modification (a view of an electric-power converter when viewed from the vehicle width direction);
FIG. 7 is three face views illustrating a component layout inside a case of the conventional electric-power converter, and (A) is a plan view, (B) is a side view, and (C) is a rear view; and
FIG. 8 is three face views illustrating a component layout inside a case of the electric-power converter employed in the in-vehicle structure of the embodiment, and (A) is a plan view, (B) is a side view, and (C) is a rear view.

### DETAILED DESCRIPTION OF EMBODIMENTS

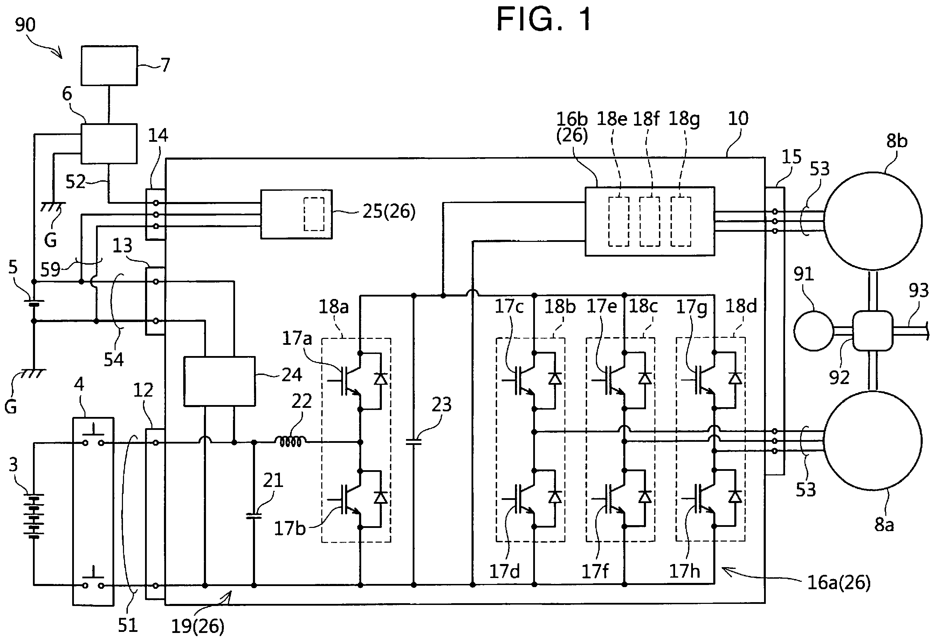

The following describes an in-vehicle structure of an embodiment with reference to the drawings. The in-vehicle structure of the embodiment is applied to a hybrid vehicle including two motors and one engine for traveling. FIG. 1 illustrates a block diagram of a driving system of a hybrid vehicle 90. Output shafts of two motors 8a, 8b and an output shaft of an engine 91 are connected to a power distribution mechanism 92. The power distribution mechanism 92 combines output torques of the motors 8a, 8b and an output torque of the engine 91 appropriately, and transmits a resultant torque to an axle 93. The power distribution mechanism 92 is more specifically a planetary gear, and the motor 8a is connected to its sun gear, the engine 91 is connected to its carrier, and the motor 8b and the axle 93 are connected to its ring gear. The power distribution mechanism 92 may transmit a part of the torque of the engine 91 to the motor 8a and may transmit a remaining torque to the axle 93. In that case, the motor 8a generates electric power with the part of the torque of the engine 91. Further, the power distribution mechanism 92 may transmit a torque of the axle 93 to the motors 8a, 8b when a driver steps on a brake pedal. In that case, the motors 8a, 8b generate electric power with the torque transmitted from the axle. The electric power obtained by the electric-power generation is used for charging of a high-voltage battery 3.

The hybrid vehicle 90 includes the high-voltage battery 3 configured to supply electric power to the motors 8a, 8b. The high-voltage battery 3 is a lithium-ion secondary battery, for example, and its output voltage is 100 volts or more. An electric-power converter 10 is connected between the high-voltage battery 3 and the motors 8a, 8b. The electric-power converter 10 converts electric power of the high-voltage battery 3 into driving electric power for the motors 8a, 8b. More specifically, the electric-power converter 10 boosts the electric power of the high-voltage battery 3 and converts the electric power thus boosted into an alternating current. Note that a system main relay 4 is connected between the high-voltage battery 3 and the electric-power converter 10. The system main relay 4 is opened and closed in conjunction with a main switch (not shown).

The following describes a circuit configuration of the electric-power converter 10. The electric-power converter 10 includes a first voltage converter circuit 19, two inverter circuits 16a, 16b, a second voltage converter circuit 24, and a circuit substrate 25. The first voltage converter circuit 19 is a so-called bidirectional DC-DC converter having a step-up function and a step-down function. The first voltage converter circuit 19 can boost a voltage of output power of the high-voltage battery 3 and supply it to the inverter circuits 16a, 16b (the step-up function). Further, the first voltage converter circuit 19 can reduce a voltage of electric power (electric power generated by the motors 8a, 8b) from the inverter circuits 16a, 16b and supply it to the high-voltage battery 3 (the step-down function). The first voltage converter circuit 19 includes a filter capacitor 21, a reactor 22, and two serially-connected power transistors 17a, 17b. A reflux diode is connected to each of the power transistors 17a, 17b in an inverse parallel manner. A circuit structure of the first voltage converter circuit 19 is well known, so its detailed description is omitted. The power transistors 17a, 17b are driven by a control circuit provided in the circuit substrate 25. Note that the two serially-connected power transistors 17a and 17b are accommodated in one power module 18a as hardware.

Two inverter circuits 16a, 16b are connected to a high-voltage side of the first voltage converter circuit 19. Structures of the inverter circuits 16a, 16b will be described. The inverter circuit 16a includes three sets of two power transistors connected in series. Power transistors 17c and 17d are connected in series, power transistors 17e and 17f are connected in series, and power transistors 17g and 17h are connected in series. A reflux diode is connected to each of the power transistors 17c to 17h in an inverse parallel manner. Three sets of serially-connected circuits are connected in parallel to each other. Each of the power transistors is driven by a control circuit provided on the circuit substrate 25, so that an alternating current is output from a midpoint of each of the serial connections. The alternating currents output from three midpoints form a three-phase alternating current. The three-phase alternating current thus output from the inverter circuit 16a is supplied to the motor 8a. As hardware, the serial connection of the power transistors 17c and 17d is accommodated in a power module 18b, the serial connection of the power transistors 17e and 17f is accommodated in a power module 18c, and the serial connection of the power transistors 17g and 17h is accommodated in a power module 18d.

Since the second inverter circuit 16b has the same structure as the inverter circuit 16a, a description thereof is omitted. A three-phase alternating current output from the inverter circuit 16b is supplied to the motor 8b. The inverter circuit 16b also includes three sets of two serially-connected power transistors, and those serial connections are accommodated in three power modules 18e to 18g, respectively. In the following description, the plurality of power transistors 17a to 17h may be referred to generally as a power transistor group 17.

A smoothing capacitor 23 is connected between the first voltage converter circuit 19 and the inverter circuits 16a, 16b. The smoothing capacitor 23 and the aforementioned filter capacitor 21 are provided so as to restrain a high-frequency fluctuation in a voltage of electric power supplied from the high-voltage battery 3.

A second voltage converter circuit 24 is connected to the high-voltage battery 3, in addition to the first voltage converter circuit 19. The second voltage converter circuit 24 reduces an output voltage of the high-voltage battery 3 to a drive voltage of accessories. The "accessories" is a general term of a device group operating at a voltage lower than the drive voltage of the motors 8a, 8b, and its operating voltage is around 10 to 50 volts. The circuit substrate 25 provided in the electric-power converter 10 and a HV controller 6 that controls a whole system of the hybrid vehicle 90 belong to the accessories. The electric power, the voltage of which is reduced by the second voltage converter circuit 24, is supplied to the circuit substrate 25, the HV controller 6, other accessories, and an auxiliary battery 5. The auxiliary battery 5 is provided so as to supply electric power to the accessories while electric power is not supplied from the electric-power converter 10. The auxiliary battery 5 and negative electrodes of the accessories are electrically conductive to each other via a vehicle body (a body ground G).

When a vehicle has a collision, the control circuit provided on the circuit substrate 25 drives the power transistor group 17 in response to a signal (a discharge instruction signal) from the HV controller 6, so as to discharge the capacitors 21, 23. More specifically, the control circuit controls the power transistor group 17 so that the electric power of the capacitors 21, 23 is discharged through the reactor 22 and the motors 8a, 8b. The circuit substrate 25, the first voltage converter circuit 19, and the inverter circuits 16a, 16b at the time of discharging the capacitors 21, 23 may be generally referred to as a discharge circuit 26 for convenience of description.

An air bag sensor 7 (an acceleration sensor) is connected to the HV controller 6. When the vehicle has a collision, the air bag sensor 7 transmits, to the HV controller 6, a signal (a collision detection signal) indicative of the collision. More specifically, when a magnitude (a magnitude of acceleration) of the collision that the vehicle has exceeds a predetermined threshold, the air bag sensor 7 transmits the collision detection signal to the HV controller 6. Upon receipt of the collision detection signal from the air bag sensor 7, the HV controller 6 opens the system main relay 4 and transmits a discharge instruction signal to the electric-power converter 10.

A connector connected to the electric-power converter 10 will be described. Four connectors are provided in the electric-power converter 10. One of them is a connector (a signal connector 14) to which a wiring harness 52 for communication of the discharge instruction signal and a low-voltage power supply harness 59 for transmitting electric power of the auxiliary battery 5 to the circuit substrate 25 are connected. Note that, in FIG. 1, only one line is illustrated as the wiring harness 52, but the wiring harness 52 can include other various signal lines. Another one of them is a connector (a high-voltage connector 12) to which a cable (a high-voltage power supply cable 51) for transmitting electric power of the high-voltage battery 3 to the electric-power converter 10 is connected. Further another one of them is a connector (a low-voltage connector 13) to which a cable (a low-voltage power supply cable 54) for transmitting output power of the second voltage converter circuit 24 to the auxiliary battery 5 is connected. Although not illustrated in FIG. 1, another communication cable (the after-mentioned communication cable 55) is also connected to the low-voltage connector 13. The communication cable 55 is a cable that connects the HV controller 6, which is a superior control device of the electric-power converter 10, to the second voltage converter circuit 24 inside the electric-power converter 10. The HV controller 6 monitors a residual quantity of the auxiliary battery 5, and controls the second voltage converter circuit 24 depending on the residual quantity. The communication cable 55 is provided for that purpose. The last one of them is a connector (a motor cable connector 15) to which a motor power cable 53 for transmitting output alternating currents of the inverter circuits 16a, 16b to the motors 8a, 8b is connected.

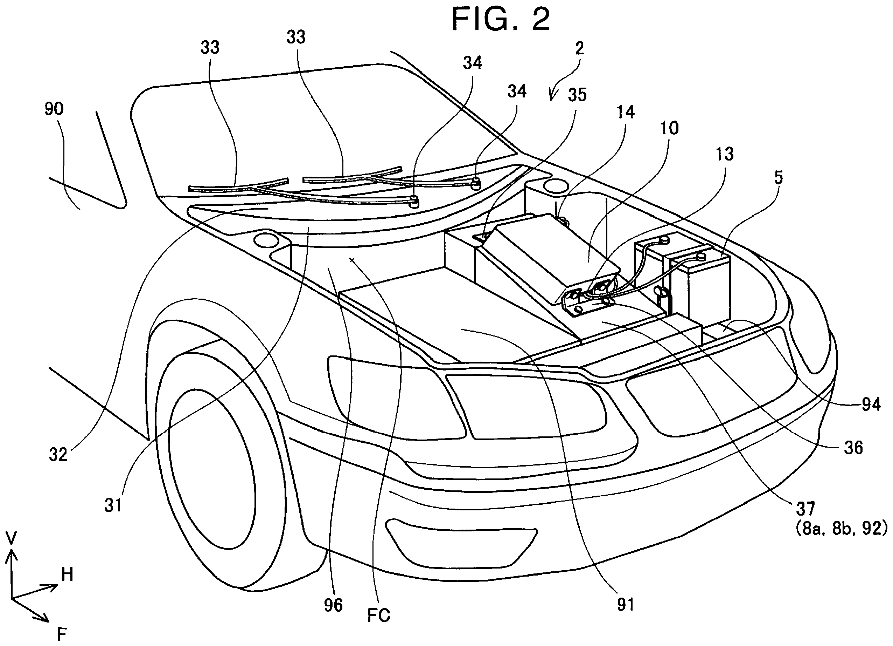

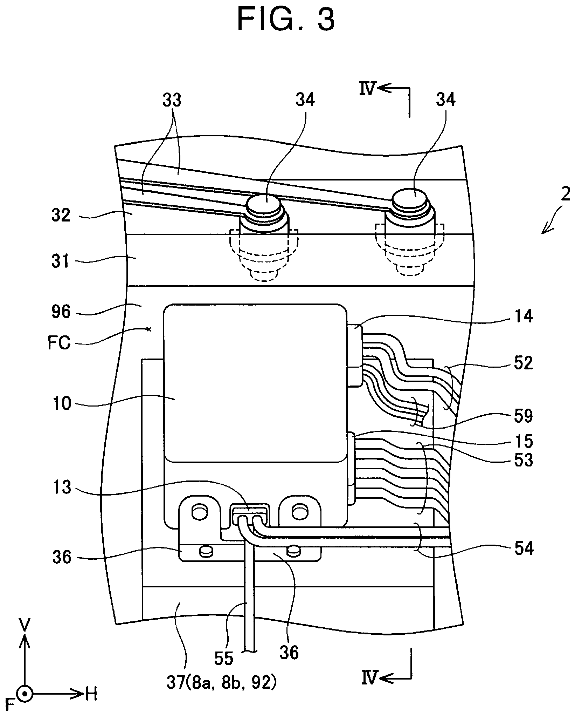

Next will be described an arrangement of the electric-power converter 10 on the vehicle and an arrangement of the connectors described above. FIG. 2 is a perspective view illustrating a device layout in a front compartment FC of the hybrid vehicle 90. In a coordinate system in FIG. 2, an F-axis indicates a vehicle front side, an H-axis indicates a vehicle width direction, and a V-axis indicates a vehicle upper side. In FIGS. 3 to 6 to be described later, each axis in their coordinate systems indicates the same meaning as above. In FIG. 2, an engine hood is not illustrated.

The engine 91, a transaxle 37, the electric-power converter 10, the auxiliary battery 5, and the like are provided in the front compartment FC. Note that various components are further provided in the front compartment FC, but components other than the above components are not described herein. In the transaxle 37, the traction motors 8a, 8b, the power distribution mechanism 92, and a differential gear are accommodated. The transaxle 37 can be expressed as a motor housing in which the traction motors 8a, 8b are accommodated. The transaxle 37 is connected to the engine 91 in the vehicle width direction. As has been described earlier, the output shaft of the engine 91, the output shafts of the motors 8a, 8b, and the axle 93 (the differential gear) are connected to the power distribution mechanism 92 inside the transaxle 37. The engine 91 and the transaxle 37 are suspended between two side members 94 extending in a vehicle front-rear direction below the front compartment FC. Note that one of the body side members is covered and therefore not observable in FIG. 2.

The electric-power converter 10 is fixed onto the transaxle 37 via a front bracket 36 and a rear bracket 35.

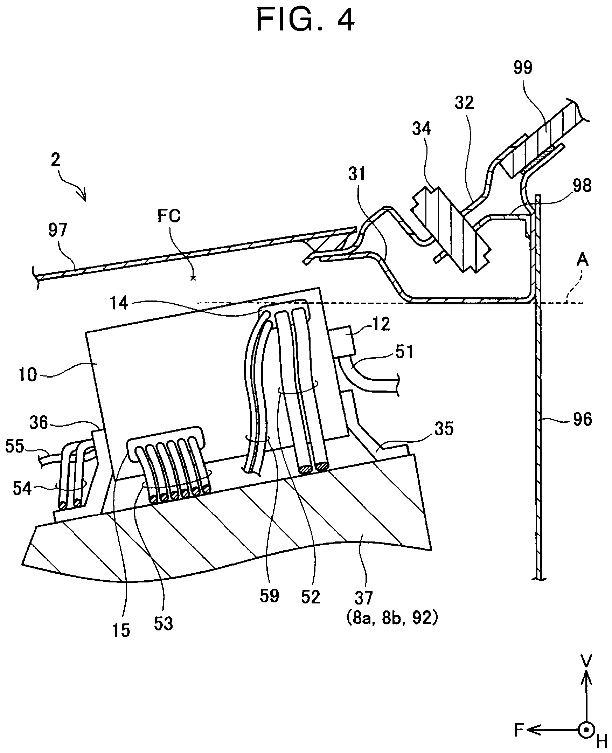

FIG. 3 illustrates a view of the electric-power converter 10 provided in the vehicle when viewed from the vehicle front side and FIG. 4 illustrates a sectional view taken along a line IV-IV in FIG. 3. FIG. 4 corresponds to a view of the electric-power converter 10 provided in the vehicle when viewed in the vehicle width direction. After FIG. 2, an in-vehicle structure of the electric-power converter 10 is indicated by a reference sign 2. In FIG. 3, the engine hood that covers the front compartment FC is not illustrated. In FIG. 4, in order to assist understanding, an internal structure of the transaxle 37 and the like is not illustrated. In the following description, with reference to FIGS. 3, 4 as well as FIG. 2, the in-vehicle structure 2 of the electric-power converter 10, particularly, an arrangement of the signal connector 14 will be described.

As illustrated in FIG. 4, due to the front bracket 36 and the rear bracket 35, a gap is secured between a top face of the transaxle 37 and the electric-power converter 10. This is to protect the electric-power converter 10 from the vibration of the engine 91 and the vibration of the motors 8a, 8b. Although not illustrated herein, a damping bush is sandwiched between the front bracket 36 and the electric-power converter 10 and between the rear bracket 35 and the electric-power converter 10. The electric-power converter 10 is supported by the front bracket 36 and the rear bracket 35, and therefore, at the time of a front collision, the electric-power converter 10 may move backward upon receipt of a collision load from the front side.

The low-voltage connector 13 is provided on a surface of the electric-power converter 10, the surface facing the vehicle front side, and the signal connector 14 and the motor cable connector 15 are provided on a side face of the electric-power converter 10, the side face facing in the vehicle width direction. The signal connector 14 is attached on the vehicle front side relative to a rear end of the electric-power converter 10. The high-voltage connector 12 is provided on a surface of the electric-power converter 10, the surface facing a vehicle rear side. As has been described earlier, the low-voltage power supply cable 54 (a cable for transmitting output power of the second voltage converter circuit 24 to the auxiliary battery 5) and the communication cable 55 are connected to the low-voltage connector 13, and the wiring harness 52 for communication of the discharge instruction signal and the low-voltage power supply harness 59 are connected to the signal connector 14. Note that various signal cables are bundled up in the wiring harness 52 as well as the signal cable for communication of the discharge instruction signal, so the wiring harness 52 is illustrated thickly in FIGS. 3, 4. The motor power cable 53 (a cable for transmitting output alternating currents of the inverter circuits 16a, 16b to the motors 8a, 8b) is connected to the motor cable connector 15. The high-voltage power supply cable 51 (a cable for transmitting electric power of the high-voltage battery 3 to the electric-power converter 10) is connected to the high-voltage connector 12.

A cowl top 31 made of metal is placed on the vehicle rear side of the front compartment FC. The cowl top 31 extends in the vehicle width direction, and as illustrated in FIG. 4, a section cut along a plane expanding in the vehicle front-rear direction (an F-axis direction in the figure) and a vehicle up-down direction (a V-axis direction in the figure) has a curved shape opened upward. In other words, the cowl top 31 has a shape like a halfpipe opened upward. The cowl top 31 curves so that its bottom face gradually becomes high toward the vehicle front side. A rear edge of the cowl top 31 makes contact with a lower ledge of a windshield 99, and an engine hood 97 that covers the front compartment FC makes contact with its front edge (see FIG. 4). A wiper pivot 34 is placed inside the curve in an upper part of the cowl top 31. The wiper pivot 34 is supported by a pivot holder 98. The pivot holder 98 is fixed to the cowl top 31. The upper part of the cowl top 31 that is opened upward is covered with a cowl louver 32 made of resin. An upper end of the wiper pivot 34 penetrates through the cowl louver 32, and a part thereof is exposed. A wiper 33 is connected to a part of the wiper pivot 34 which sticks out from the cowl louver 32. Note that the wiper 33 is not illustrated in FIG. 4. A dash panel 96 continues below the cowl top 31. The dash panel 96 is a metal plate that separates the front compartment FC from a cabin. Note that the cowl top 31 may be called a cowl top panel.

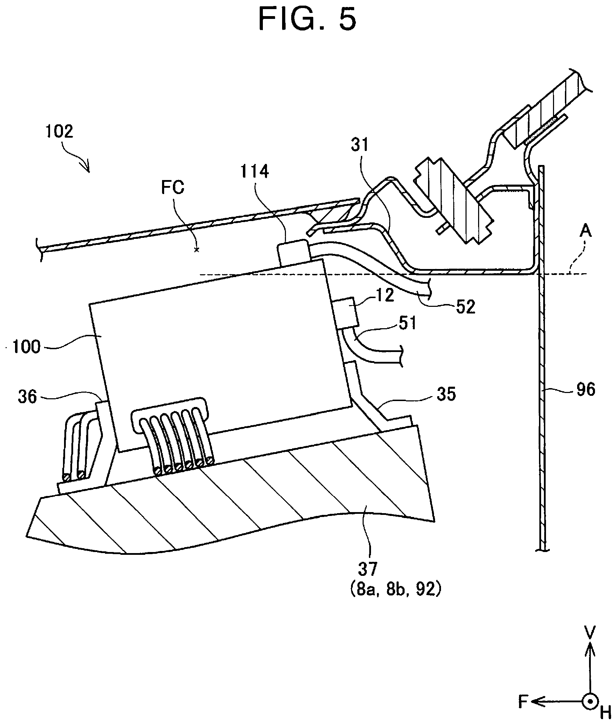

In order to describe the advantage of the in-vehicle structure 2 in FIGS. 2 to 4, FIG. 5 illustrates an in-vehicle structure 102 of an electric-power converter 100 including a signal connector 114 provided on its top face, as a comparative example. Differences between FIG. 4 and FIG. 5 are only a mounted position of the signal connector and whether another communication cable 55 is provided or not. FIG. 4 and FIG. 5 have the same positional relationship between the electric-power converter 10 (the electric-power converter 100 in the comparative example) and the cowl top 31. A broken line A in FIGS. 4 and 5 indicates a height of a bottom end of the cowl top 31. As has been described earlier, the electric-power converter 10 (the electric-power converter 100) is supported on the transaxle 37 by the front bracket 36 and the rear bracket 35. At the time of a front collision, the electric-power converter 10 may move backward due to a collision load from the front side. Further, when the electric-power converter 10 (the electric-power converter 100) is fixed onto the transaxle 37, the electric-power converter 10 (the electric-power converter 100) is placed in front of the cowl top 31. In the meantime, as has been described earlier, the cowl top 31 has such a shape that its bottom face gradually becomes high toward the vehicle front side. When the signal connector 114 is provided on the top face of the electric-power converter 100 as illustrated in FIG. 5, the signal connector 114 makes contact with the cowl top 31 at the time when the electric-power converter 100 moves backward, so that the signal connector 114 might be damaged. As described above with reference to FIG. 1, at the time of a collision, the electric-power converter 10 (the electric-power converter 100) receives a discharge instruction signal via the wiring harness 52 and the signal connector 14 (the signal connector 114), so as to discharge the capacitor provided therein. In a case of the in-vehicle structure 102 of FIG. 5, when the signal connector 114 is damaged due to the contact with the cowl top 31 at the time of the collision, the discharge instruction signal might not reach a circuit substrate 25 inside the electric-power converter 100. In the meantime, in a case of the in-vehicle structure 2 of the embodiment (FIG. 4), a part of the signal connector 14 is positioned higher than a bottom end of the cowl top 31, but the signal connector 14 is provided on the side face of the electric-power converter 10 which faces in the vehicle width direction. When the electric-power converter 10 moves backward, the electric-power converter 10 makes contact with the cowl top 31 earlier than the signal connector 14 so as to push the cowl top 31 rearward. Accordingly, the signal connector 14 provided on the surface of the electric-power converter 10 which faces in the vehicle width direction can avoid the contact with the cowl top 31. Note that, when the electric-power converter 10 moves backward to push the cowl top 31 rearward, the cowl top 31 is bent by a corner of a boundary between the side face and the rear face of the electric-power converter 10. Apart of the cowl top 31 comes close to the side face of the electric-power converter 10. Since the signal connector 14 is positioned on the vehicle front side relative to the rear end of the electric-power converter 10, the signal connector 14 can hardly hit the cowl top 31 that is bent to come close thereto. In the in-vehicle structure 2 of the embodiment, it is possible to avoid such a situation that the signal connector 14 collides with the cowl top 31 at the time when the electric-power converter 10 moves backward, so that the discharge instruction signal is transmitted to the discharge circuit provided therein. As a result, the internal capacitor is discharged surely.

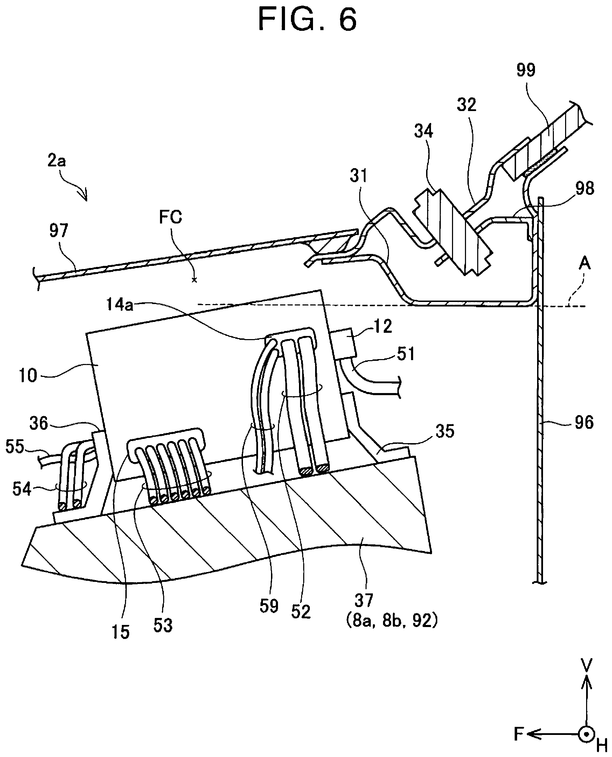

An in-vehicle structure 2a of a modification is illustrated in FIG. 6. In the in-vehicle structure 2 of FIG. 4, a part of the signal connector 14 is positioned higher than the bottom end of the cowl top 31. In the in-vehicle structure 2a of FIG. 6, a signal connector 14a is provided at a position lower than the bottom end of the cowl top 31. With such a configuration, it is possible to more surely protect the signal connector 14a from a collision with the cowl top 31 at the time of a front collision.

In the in-vehicle structure 2 of FIG. 4 and the in-vehicle structure 2a of FIG. 6, the high-voltage connector 12 is provided on the surface (the rear face) of the electric-power converter 10 at a position lower than the cowl top 31, the surface facing the vehicle rear side. Accordingly, even if the electric-power converter 10 moves backward, the high-voltage connector 12 does not make contact with the cowl top 31. Hereby, the high-voltage connector 12 is protected, and it is avoided that a conductor to which a high voltage is applied is exposed. Further, the providing of the high-voltage connector 12 on the rear face of the electric-power converter 10 has such an advantage that, even if the vehicle collides with an obstacle from a lateral side of the vehicle, the high-voltage connector 12 can hardly be damaged.

Below are notes regarding the in-vehicle structure described in the embodiment. The electric-power converter 10 employed in the in-vehicle structure of the embodiment includes the signal connector 14 (14a) provided on a side face of its housing. The providing of the signal connector 14 (14a) on the side face of the housing has such an advantage that moisture content can hardly enter the housing in comparison with a case where the signal connector 14 (14a) is provided on the top face of the housing.

In the electric-power converter 10 of the embodiment, the wiring harness 52 for communication of the discharge instruction signal and the low-voltage power supply harness 59 for transmitting electric power of the auxiliary battery 5 to the circuit substrate 25 are connected to the signal connector 14 (14a). The low-voltage power supply harness 59 may be a structure connected to the electric-power converter 10 not by the signal connector 14 (14a), but by other connectors.

The in-vehicle structure 2, 2a of the embodiment is applied to a hybrid vehicle including motors and an engine. The in-vehicle structure described in the present specification is also preferably applied to an electric vehicle or a fuel-cell vehicle that does not include an engine.

The wiring harness 52 of the embodiment corresponds to one example of a "wiring harness for communication of a discharge instruction signal" in Claims. The transaxle 37 in which the motors 8a, 8b are accommodated corresponds to one example of a "motor housing" in Claims.

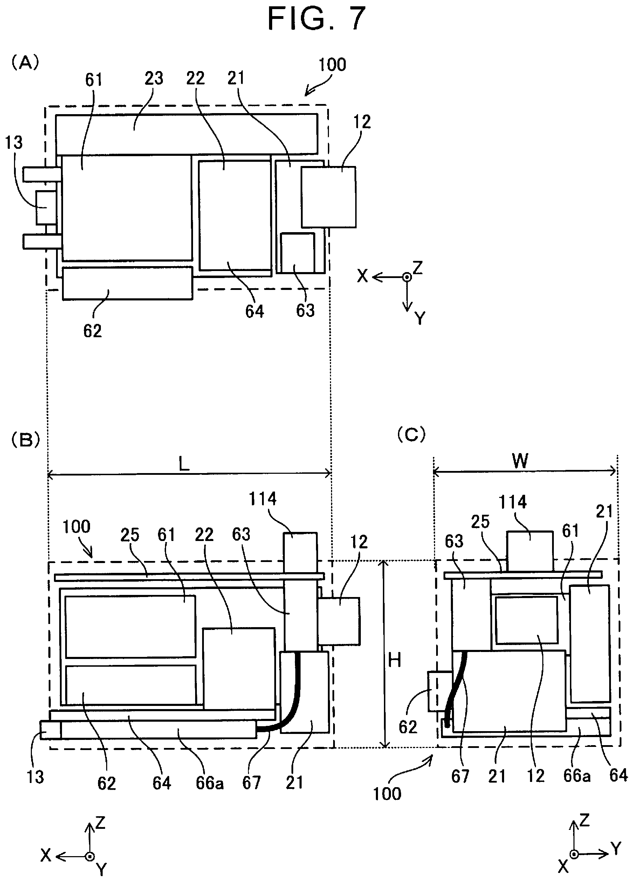

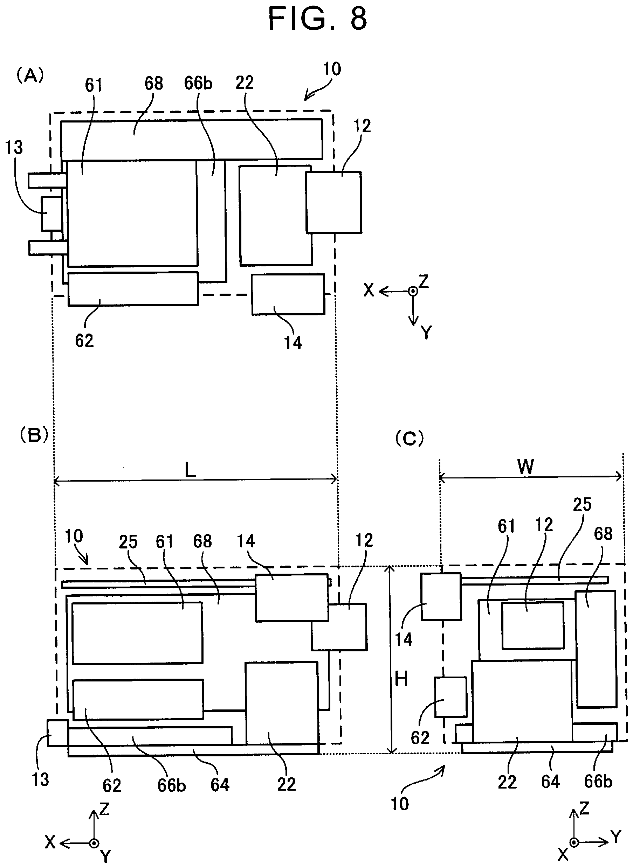

In the electric-power converter 100 of FIG. 5, the signal connector 114 is provided on its top face, and in the electric-power converter 10 of FIG. 4, the signal connector 14 is provided on the side face facing in the vehicle width direction. The reason why the position of the signal connector can be changed from the top face of the electric-power converter 100 to the surface that faces in the vehicle width direction is because the components accommodated in the housing of the electric-power converter 10 are downsized and the layout thereof is changed. The following describes the difference between a component layout inside the electric-power converter 100 of FIG. 5 and a component layout inside the electric-power converter 10 of FIG. 4. FIG. 7 is a schematic view of the component layout of the electric-power converter 100 of FIG. 5, and FIG. 8 is a schematic view of the component layout of the electric-power converter 10 of FIG. 4. In FIGS. 7, 8, (A) indicates a plan view, (B) indicates a side view, and (C) indicates a rear view. In the coordinate system in the figures, an X-axis corresponds to the vehicle front-rear direction, a Y-axis corresponds to the vehicle width direction, and a Z-axis corresponds to the vehicle up-down direction. In the following description, for convenience of description, an X-axis positive direction is referred to as a "front side," and an X-axis negative direction is referred to as a "rear side." Further, a Z-axis positive direction is referred to as an "upper side," and a Z-axis negative direction is referred to as a "lower side." A Y-axis direction is referred to as the vehicle width direction.

In three face views of FIGS. 7, 8, only a contour of the housing is indicated by a broken line so that the component layout inside the housing can be understood. Further, in the plan view of (A) of FIG. 7, the circuit substrate 25 and the signal connector 114 are not illustrated. In the plan view of (A) of FIG. 8, the circuit substrate 25 is not illustrated. In FIGS. 7, 8, wiring lines that connect the components to each other are not illustrated except for an inner cable 67 of FIG. 7.

The electric-power converter 100 and the electric-power converter 10 have the same outside diameter dimension (length L × width W × height H). The component layout of the electric-power converter 100 will be described first. In the electric-power converter 100, a converter unit 66a is placed in a lowermost layer of a case. The converter unit 66a corresponds to the second voltage converter circuit 24 in FIG. 1. The low-voltage connector 13 is placed in front of the converter unit 66a. As illustrated in FIG. 5, the low-voltage connector 13 is exposed on a front face (a surface that faces toward the vehicle front side) of the electric-power converter 100.

A cooler 64 is placed so as to make contact with a top face of the converter unit 66a. A reactor 22 is placed so as to make contact with a top face of the cooler 64. A power stack 61 is placed in front of the reactor 22. The power stack 61 is a device in which the plurality of power modules 18a to 18g described in FIG. 1 and a plurality of cooling plates (not shown) are laminated. In FIGS. 7, 8, the power stack 61 is simply illustrated as a rectangular solid. The aforementioned cooler 64 mainly cools down the converter unit 66a and the reactor 22. The power modules 18a to 18g with a large amount of heat generation are cooled by the plurality of cooling plates in the power stack 61.

A current sensor unit 62 is placed on one side of the power stack 61 in the vehicle width direction, and a smoothing capacitor 23 is placed on the other side. The current sensor unit 62 is a unit for measuring a current of each phase of two sets of three-phase alternating currents. A part (a part exposed from the case of the electric-power converter 100) of the current sensor unit 62 corresponds to the aforementioned motor cable connector 15.

A filter capacitor 21 is placed behind the reactor 22. An inner connector 63 is positioned above the filter capacitor 21. The high-voltage connector 12 is placed behind the inner connector 63. The circuit substrate 25 is placed above the smoothing capacitor 23, the power stack 61, and the inner connector 63. The inner connector 63 is connected to the converter unit 66a by the inner cable 67, and an upper end of the inner connector 63 is connected to the circuit substrate 25. The circuit substrate 25 controls the converter unit 66a via the inner connector 63 and the inner cable 67.

The signal connector 114 is connected to the top face of the circuit substrate 25. An upper part of the signal connector 114 is exposed from the top face of the electric-power converter 100. That is, the signal connector 114 is provided on the top face of the electric-power converter 100.

With reference to FIG. 8, the following describes the inner layout of the electric-power converter 10. In the electric-power converter 10, a cooler 64 is placed in a bottom end of a housing, and a converter unit 66b is placed thereon. The converter unit 66b corresponds to the second voltage converter circuit 24 in FIG. 1. The converter unit 66b is downsized in comparison with the converter unit 66a of FIG. 7, and its length in the vehicle front-rear direction is shortened. In the electric-power converter 10, the converter unit 66b is shortened, so that the reactor 22 is placed behind the converter unit 66b. Further, in the electric-power converter 100, the inner connector 63 is placed above the reactor 22, but in the electric-power converter 10, the inner connector 63 and the inner cable 67 can be eliminated. The reason is as follows. As has been described earlier, the electric-power converter 10 (and the electric-power converter 100) is connected to the superior HV controller 6, and the HV controller 6 controls the second voltage converter circuit 24 (the converter unit 66b). In the electric-power converter 100, a communication line from the HV controller 6 is connected to the signal connector 114 on the top face of the electric-power converter 100, and the converter unit 66a and the HV controller 6 are connected to each other via the signal connector 114, the inner connector 63, and the inner cable 67. In the electric-power converter 10 of the embodiment, the communication cable (the communication cable 55) from the HV controller 6 is connected to the low-voltage connector 13 placed on the front face of the electric-power converter 10. The HV controller 6 is connected to the converter unit 66b via the communication cable 55 and the low-voltage connector 13 positioned right in front of the converter unit 66b. With this structure, the inner connector 63 and the inner cable 67 can be eliminated.

Further, in the electric-power converter 10, a capacitor unit 68 is placed on structure, the inner connector 63 and the inner cable 67 can be eliminated.

Further, in the electric-power converter 10, a capacitor unit 68 is placed on a lateral side of a power stack 61. The capacitor unit 68 accommodates two capacitor elements therein. One capacitor element corresponds to the filter capacitor 21 of FIG. 1, and the other capacitor element corresponds to the smoothing capacitor 23 of FIG. 1. In comparison with the electric-power converter 100, the electric-power converter 10 employs small capacitor elements and unifies two capacitor elements as one unit, so as to increase space efficiency.

With such differences, the electric-power converter 10 can secure a sufficient space on the lateral side (the side along the vehicle width direction) of the circuit substrate 25, so that the signal connector 14 can be placed in the space.

The embodiment of the in-vehicle structure of an electric-power converter configured to convert electric power of an electric power source into driving electric power for a traction motor may be defined as follows. The electric-power converter is fixed onto a motor housing in which the motor is accommodated, the electric-power converter is provided ahead of a cowl top in a front-rear direction of a vehicle, a high voltage connector is configured to connect to a power cable that transmits the electric power of the electric power source to the electric-power converter, the high voltage connector is provided on a rear surface of the electric-power converter in the front-rear direction of the vehicle, the high voltage connector is provided at a position lower than the cowl top, the electric-power converter includes a capacitor configured to restrain a high-frequency fluctuation in a voltage of the electric power supplied from the electric power source, and a discharge circuit configured to discharge the capacitor, a signal connector is configured to connect to a wiring harness that transmits a discharge instruction signal for operating the discharge circuit to the discharge circuit at a time of a collision, the signal connector is provided on one of right and left side surfaces of the electric-power converter in a width direction of the vehicle, and the signal connector is provided ahead of a rear end of the electric-power converter in the front-rear direction of the vehicle. The specific example of the invention has been explained in detail.

## Claims

1. An in-vehicle structure comprising:
an electric-power converter (10) configured to convert electric power of an electric power source (3) into driving electric power for a traction motor (8a, 8b); and
a motor housing (37) in which the traction motor (8a, 8b) is accommodated, wherein
the electric-power converter (10) is fixed onto the motor housing (37),
**characterized in that** the electric-power converter (10) is provided in front of a cowl top (31) in a front-rear direction of a vehicle (90), the cowl top (31) being a panel extending in a vehicle width direction,
a high voltage connector (12) is configured to connect to a power cable (51) that transmits the electric power of the electric power source (3) to the electric-power converter (10),
the high voltage connector (12) is provided on a rear surface of the electric-power converter (10) in the front-rear direction of the vehicle,
the high voltage connector (12) is provided at a position lower than the cowl top (31),
the electric-power converter (10) includes a capacitor (21, 23) configured to restrain a high-frequency fluctuation in a voltage of the electric power supplied from the electric power source (3), and a discharge circuit (26) configured to discharge the capacitor (21, 23),
a signal connector (14) is configured to connect to a wiring harness (52) that transmits a discharge instruction signal for operating the discharge circuit (26) to the discharge circuit at a time of a collision,
the signal connector (14) is provided on one of right and left side surfaces of the electric-power converter (10) in a width direction of the vehicle (90), and
the signal connector (14) is provided on the vehicle front side relative to a rear end of the electric-power converter (10) in the front-rear direction of the vehicle.

2. The in-vehicle structure according to claim 1, wherein
the signal connector is provided on the electric-power converter at a position lower than the cowl top.

## Patentansprüche

1. Fahrzeuginterne Struktur, umfassend:
einen elektrischen Energiewandler (10), der dazu ausgestaltet ist, elektrische Energie einer elektrischen Energiequelle (3) in elektrische Antriebsenergie für einen Traktionsmotor (8a, 8b) umzuwandeln, und
ein Motorgehäuse (37), in welchem der Traktionsmotor (8a, 8b) untergebracht ist, wobei
der elektrische Energiewandler (10) an dem Motorgehäuse (37) fixiert ist,
**dadurch gekennzeichnet, dass**
der elektrische Energiewandler (10) in einer Front-Heck-Richtung eines Fahrzeugs (90) vor einem Windlauf (31) vorgesehen ist, wobei der Windlauf (31) eine Platte ist, die sich in einer Fahrzeugbreitenrichtung erstreckt,
ein Hochspannungs-Verbinder (12) dazu ausgestaltet ist, ein Stromkabel (51) anzuschließen, welches elektrische Energie der elektrischen Energiequelle (3) an den elektrischen Energiewandler (10) überträgt,
der Hochspannungs-Verbinder (12) an einer hinteren Oberfläche des elektrischen Energiewandlers (10) in der Front-Heck-Richtung des Fahrzeugs vorgesehen ist,
der Hochspannungs-Verbinder (12) an einer tieferen Position als der Windlauf (31) vorgesehen ist,
der elektrische Energiewandler (10) einen Kondensator (21, 23), der dazu ausgestaltet ist, Hochfrequenz-Schwankungen in einer Spannung der elektrischen Energie, die von der elektrischen Energiequelle (3) geliefert wird, zu begrenzen, und eine Entladeschaltung (26) beinhaltet, die dazu ausgestaltet ist, den Kondensator (21, 23) zu entladen,
ein Signalverbinder (14) dazu ausgestaltet ist, mit einem Kabelbaum (52) verbunden zu werden, der zum Zeitpunkt einer Kollision ein Entladeanweisungs-Signal zum Betreiben der Entladeschaltung (26) an die Entladeschaltung überträgt,
der Signalverbinder (14) auf einer von einer rechten und linken Seitenfläche des elektrischen Energiewandlers (10) in einer Breitenrichtung des Fahrzeugs (90) vorgesehen ist und
der Signalverbinder (14) auf der Fahrzeugvorderseite relativ zu einem hinteren Ende des elektrischen Energiewandlers (10) in der Front-Heck-Richtung des Fahrzeugs vorgesehen ist.

2. Fahrzeuginterne Struktur nach Anspruch 1, wobei
der Signalverbinder an dem elektrischen Energiewandler an einer tieferen Position als der Windlauf vorgesehen ist.

## Revendications

1. Structure dans un véhicule comprenant :
un convertisseur de puissance électrique (10) configuré pour convertir de l'énergie électrique d'une source d'énergie électrique (3) en puissance électrique d'entraînement pour un moteur de traction (8a, 8b) ; et
un logement de moteur (37) dans lequel le moteur de traction (8a, 8b) est reçu, le convertisseur de puissance électrique (10) étant fixé sur le logement de moteur (37),
**caractérisé en ce que** le convertisseur de puissance électrique (10) est prévu devant un dessus de tablier (31) selon une direction avant-arrière d'un véhicule (90), le dessus de tablier (31) étant un panneau s'étendant dans une direction de largeur de véhicule,
un connecteur à haute tension (12) est configuré pour se raccorder à un câble électrique (51) qui transmet l'énergie électrique de la source d'énergie électrique (3) au convertisseur de puissance électrique (10),
le connecteur à haute tension (12) est prévu sur une surface arrière du convertisseur de puissance électrique (10) dans la direction avant-arrière du véhicule,
le connecteur à haute tension (12) est prévu dans une position plus basse que le dessus de tablier (31),
le convertisseur de puissance électrique (10) comprend un condensateur (21, 23) configuré pour limiter une fluctuation à haute fréquence dans une tension de l'énergie électrique délivrée par la source d'énergie électrique (3), et un circuit de décharge (26) configuré pour décharger le condensateur (21, 23),
un connecteur de signal (14) est configuré pour se raccorder à un faisceau de câblage (52) qui transmet au circuit de décharge au moment d'une collision un signal d'instruction de décharge pour mettre en œuvre le circuit de décharge (26),
le connecteur de signal (14) est prévu sur une surface de surfaces latérales droite et gauche du convertisseur de puissance électrique (10) dans une direction de largeur du véhicule (90), et
le connecteur de signal (14) est prévu sur le côté avant de véhicule par rapport à une extrémité arrière du convertisseur de puissance électrique (10) dans la direction avant-arrière du véhicule.

2. Structure dans un véhicule selon la revendication 1, dans laquelle
le connecteur de signal est prévu sur le convertisseur de puissance électrique dans une position plus basse que le dessus du tablier.
